Europäisches Patentamt

European Patent Office

Office européen des brevets

(11) Publication number: 0 394 807 A2

# EUROPEAN PATENT APPLICATION

(21) Application number: 90107224.9

(22) Date of filing: 17.04.90

(51) Int. Cl.5: H03F 1/30

(30) Priority: 27.04.89 IT 2028089

(43) Date of publication of application:
31.10.90 Bulletin 90/44

(84) Designated Contracting States:
DE FR GB NL SE

(71) Applicant: SGS-THOMSON
MICROELECTRONICS s.r.l.
Via C. Olivetti, 2
I-20041 Agrate Brianza Milano(IT)

(72) Inventor: Betti, Giorgio
Viale Premuda 24
I-20120 Milano(IT)

Inventor: Zuffada, Maurizio
Piazza Anita Garibaldi 8
I-20100 Milano(IT)
Inventor: Sacchi, Fabrizio
Via Corti 55
I-27030 Gambrana (Pavia)(IT)
Inventor: Gornati, Silvano
Via G. Puccini 11
I-20010 Casorezzo (Milan)(IT)

(74) Representative: Modiano, Guido et al
MODIANO, JOSIF, PISANTY & STAUB
Modiano & Associati Via Meravigli, 16
I-20123 Milano(IT)

(54) Voltage buffer stage with temperature-independent output.

(57) A voltage buffer stage with temperature-independent output comprising a first transistor ($T_1$) with a first conductivity type, having collector and emitter terminals interposed between the supply line ($V_{cc}$) and the ground and a base terminal which receives an input voltage signal ($V_i$), a second transistor ($T_2$) with the opposite conductivity type which has collector and emitter terminals interposed respectively between the ground and the supply line and a base terminal connected to the emitter terminal of the first transistor, a sensor ($T_3$) for detecting the base-emitter voltage drop ($V_{BE2}$) of the second transistor and a current source ($T_4$) controlled by the voltage drop sensor and generating a corresponding control current ($I_{c4}$) which is fed to the first transistor ($T_1$) and forces it to operate with a base-emitter voltage drop ($V_{BE1}$) equal to the base-emitter voltage drop ($V_{BE2}$) of the second transistor.

Fig.4

EP 0 394 807 A2

EP 0 394 807 A2

## VOLTAGE BUFFER STAGE WITH TEMPERATURE-INDEPENDENT OUTPUT

The present invention relates to a voltage buffer stage with temperature-independent output.

As is known, in electronic circuits it is often necessary to transfer a thermally stable voltage, which can vary within a range of a few volts, to one or more user blocks. In such cases it is necessary to have a buffer or buffer stage which provides high impedance toward the input source and low impedance toward the output. In many applications it is furthermore required that the buffer output voltage be independent of the temperature variations to which the integrated circuit is subject.

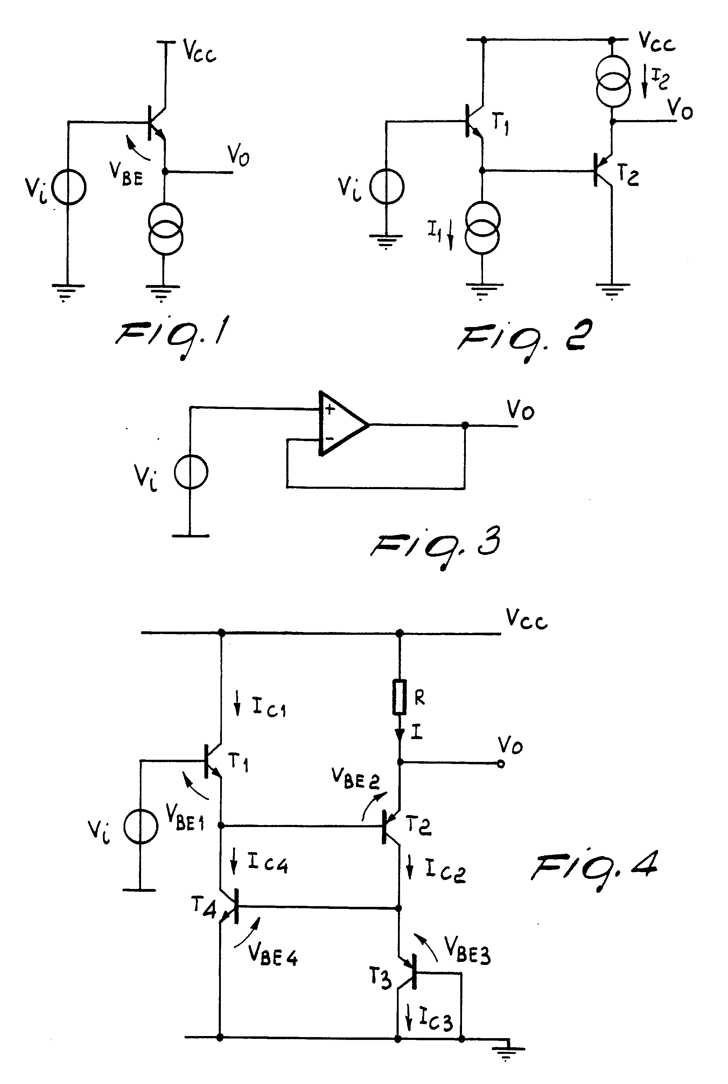

Various solutions are known and currently used as voltage buffer; the simplest among them comprises a transistor in common-collector configuration, also termed emitter follower, as shown in figure 1. Though it is convenient for its simplicity, this structure however has the disadvantage that the output voltage $V_o$ is temperature-dependent. The following relation is in fact true for said structure:

$$V_o = V_i - V_{BE}$$

and

$$\frac{\partial V_o}{\partial T} = - \frac{\partial V_{BE}}{\partial T}$$

where $V_i$ is the input voltage, $V_{BE}$ is the base-emitter drop and $V_o$ is the output voltage at the emitter of the transistor assuming that the input voltage $V_i$ is thermally stable.

A certain correction of the disadvantage featured by the above structure can be obtained by connecting the output of the transistor of figure 1 to a further transistor of the opposite conductivity type (in the illustrated example, of the PNP type, since the first transistor is of the NPN type), as shown in figure 2.

For this structure, the output voltage is given by the equation

$V_o = V_i - V_{BE1} + V_{BE2}$

where $V_{BE1}$ and $V_{BE2}$ are the base-emitter drops of $T_1$ and $T_2$ respectively.

In practice, with this structure the transistor $T_2$ is intended to compensate the effect of the transistor $T_1$, and indeed this can be achieved for a given working point by adequately designing the two current sources $I_1$ and $I_2$; however, since the thermal drift of $V_{BE}$ is different for NPN-type and PNP-type transistors, correct temperature compensation is not achieved.

Another known structure for implementing a voltage buffer with the indicated characteristics consists of an operational amplifier connected in unit feedback configuration (see figure 3). This structure solves the thermal stability problem, but at the expense of a greater circuital complexity which is also due to the need to compensate the operational amplifier to avoid the risk of auto-oscillations.

Given this situation, the aim of the present invention is to provide a voltage buffer stage the output whereof is substantially independent of the operative temperature of the integrated circuit comprising said buffer stage, so that any variations of said temperature or of the external temperature do not affect the output voltage of said buffer stage.

Within this aim, a particular object of the present invention is to provide a buffer stage which can operate on input voltages which can vary within a range of a few volts, substantially preserving the desired temperature-independence.

An important object of the present invention is to provide a buffer stage which has a simple circuit structure, has a small size, can be easily integrated and in particular does not require frequency compensations.

Still another object of the present invention is to provide a buffer stage which is highly versatile and can vary the slope of the output characteristic within wide margins.

Not least object of the present invention is to provide a buffer stage which is highly reliable and which does not require, for its manufacture, devices or procedures which differ from those commonly in use in the electronics industry.

This aim, the objects mentioned and others which will become apparent hereinafter are achieved by a voltage buffer stage with temperature-independent output, as defined in the accompanying claims.

In practice, the invention is based on the observation that the diagram shown in figure 2 can be taken

2

as a basis for developing a voltage buffer, and that in order to obtain a temperature compensation of the output voltage it is not necessary that the two transistors operate at the same current but only that their base-emitter drops be kept equal.

The characteristics and advantages of the invention will become apparent from the description of a preferred but not exclusive embodiment, illustrated only by way of non-limitative example in the accompanying drawings, wherein:

figure 1 shows a known solution in emitter follower configuration;

figure 2 shows another known solution with a second compensation transistor;

figure 3 shows a further known solution with operational amplifier; and

figure 4 is a view of the buffer stage according to the invention.

Figures 1-3, which illustrate three prior art solutions which have already been described and are in any case well-known, are not described hereinafter.

Reference should instead be made to figure 4, which illustrates the voltage buffer according to the invention. As can be seen, the buffer comprises a pair of transistors $T_1$ and $T_2$, similar to the transistors of the solution according to figure 2 and therefore indicated by the same reference numerals. In detail, the transistor $T_1$, here of the NPN type, has its base terminal receiving the input voltage $V_i$ which is to be transferred at the output to one or more loads, its collector terminal connected to the supply voltage line $V_{cc}$ which defines a first reference potential line, and its emitter terminal connected to the base terminal of the output transistor $T_2$ which has opposite conductivity type with respect to $T_1$ and is therefore of the PNP type. The transistor $T_2$ is in turn connected, with its emitter terminal, to the supply voltage $V_{cc}$ through a resistor R. The emitter terminal of $T_2$ also defines the buffer output feeding the output voltage $V_o$, which is required to be variable correspondingly to the input voltage and to be temperature-independent.

According to the invention, a structure is provided for detecting the base-emitter drop of $T_2$ and generating a corresponding control current which is sent to $T_1$ to force the latter to operate at the same $V_{BE}$ as $T_2$, independently of the external conditions, in particular of the temperature of the stage. In the illustrated embodiment, said structure is provided between the transistors $T_1$ and $T_2$ on one side and the ground (which defines a second reference potential line) on the other. In practice, detection of $V_{BE}$ of $T_2$ is performed by a transistor $T_3$ identical to $T_2$, i.e. produced with the same technology and of the same type, i.e. PNP in the present case, with the same emitter area and possibly integrated physically proximate thereto within the integrated circuit. $T_3$ is connected to the collector terminal of $T_2$ with its emitter terminal, and to the ground with its collector terminal, and is diode-connected, i.e. its base is short-circuited to its collector terminal. The control current is instead generated by a fourth transistor $T_4$ which is identical to $T_1$, i.e. produced with the same technology, of the NPN type, with the same emitter area and is possibly integrated proximate to $T_1$. $T_4$ has its emitter terminal connected to the ground, its base terminal connected to the emitter of $T_3$ and its collector terminal connected to the emitter of $T_1$ (and therefore to the base of $T_2$).

In the described circuit, the output voltage $V_o$ is given (as in the known structure of figure 2) by:

$V_o = V_i - V_{BE1} + V_{BE2}$     (1)

For the stage according to the invention, however, $V_{BE1}$ and $V_{BE2}$ are forced to be equal. In fact, except for second-order effects, such as the Early effect, which can be considered negligible, since $T_2$ and $T_3$ operate with the same collector current ($I_{C2} = I_{C3}$) and are identical to one another, the base-emitter drops of the two transistors are also equal and therefore

$V_{BE2} = V_{BE3}$.

Due to the parallel connection between the base-emitter junctions of $T_3$ and $T_4$, the base-emitter drop of $T_4$ is forced to be equal to $V_{BE3}$. Therefore

$V_{BE4} = V_{BE3} = V_{BE2}$.

Since $T_1$ and $T_4$, which have identical dimensions, are also flown by the same current ($I_{C4} = I_{C1}$), the following is consequently obtained:

$V_{BE1} = V_{BE4} = V_{BE2}$.

Thus in equation (1), which provides the output voltage, the two base-emitter drops cancel one another and therefore

$V_o = V_i$

with $2V_{BE} \leq V_i \leq V_{cc}$.

In practice, $T_3$ operates as a voltage sensor which controls the operation of $T_4$, which represents a control current source which feeds $T_1$ with such a control current that the latter is forced to operate at the same $V_{BE}$ as $T_2$. The described structure therefore ensures that $V_{BE1}$ can compensate with sufficient precision the thermal variations of $V_{BE2}$, in a wide range of $V_i$.

As can be seen from the above description, the invention fully achieves the proposed aim and objects.

A voltage buffer has in fact been provided which, as explained above, is thermally compensated, is circuitally simple and requires no frequency compensation, as is instead necessary when using a fedback operational amplifier. The input voltage can furthermore vary within a wide range without compromising the operation of the stage. Furthermore the stage according to the invention has high input impedance and low output impedance, thus satisfying this requirement as well.

The invention furthermore does not entail a high use of silicon area and requires no modification of production processes, so that it has manufacturing costs comparable to those of the simplest prior solutions, though it has better electric characteristics and high reliability.

The above described circuit furthermore provides a current

$$I = \frac{V_{cc} - V_i}{R}$$

which depends thermally only on the value of the resistor R interposed between the emitter terminal of $T_2$ and the supply voltage. It should be furthermore noted that the current which flows in the two branches of the stage is not necessarily equal, but indeed, if the emitter areas of $T_3$ and $T_4$ have different dimensions, even very different currents can be obtained.

The invention thus conceived is susceptible to numerous modifications and variations, all of which are within the scope of the inventive concept. In particular, the fact is stressed that though the described structure has an input transistor of the NPN type and an output transistor of the PNP type, the invention applies equally to dual stages in which the input transistor is of the PNP type and the output transistor is of the NPN type, and in this case the conductivity type of the transistors $T_3$ and $T_4$ obviously changes as well.

The transistors for detecting $V_{BE}$ and for generating the control current can be furthermore arranged between the respective input or output transistor and the positive supply instead of the ground.

All the details may furthermore be replaced with other technically equivalent ones.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. A voltage buffer stage with temperature-independent output, comprising a first transistor ($T_1$) with a first conductivity type, having collector and emitter terminals interposed between a first and a second reference potential lines and a base terminal receiving an input voltage signal ($V_i$), said first transistor ($T_1$) generating a first voltage drop ($V_{BE1}$) between its base and emitter terminals, a second transistor ($T_2$) with an opposite conductivity type, having collector and emitter terminals respectively interposed between said second and said first reference potential lines and a base terminal connected to the emitter terminal of said first transistor ($T_1$), said second transistor ($T_2$) generating a second voltage drop ($V_{BE2}$) between its base and emitter terminals, characterized by means ($T_3$) for detecting said second voltage drop ($V_{BE2}$) of said second transistor ($T_2$) and current source means ($T_4$) controlled by said means ($T_3$) for detecting to supply said first transistor ($T_1$) with a corresponding control current ($I_{c4}$) forcing said first transistor ($T_1$) to operate at a working point at which said first voltage drop ($V_{BE1}$) between said base and emitter terminals, is equal in absolute value to said second voltage drop ($V_{BE2}$) of said second transistor ($T_2$).

2. A stage according to claim 1, characterized by resistive means (R) interposed between said second transistor ($T_2$) and said first reference potential line ($V_{cc}$), said resistive means defining a resistance and generating a current (I) thermally depending exclusively upon said resistance (R).

3. A stage according to the preceding claims, characterized in that said means for detecting comprises a third transistor ($T_3$) connected in series to said second transistor ($T_2$) and flown by the same current ($I_{c3} = I_{c2}$), said third transistor having said second conductivity type and dimensions which are equal to those of said second transistor ($T_2$) so as to generate a base-emitter voltage drop ($V_{BE3}$) equal to said second voltage drop ($V_{BE2}$), and in that said source means comprises a fourth transistor ($T_4$) connected in series to said first transistor ($T_1$) and flown by the same current ($I_{c4} = I_{c1}$), said fourth transistor ($T_4$) having its base and emitter terminals connected in parallel to the base and emitter terminals of said third transistor ($T_3$), having said first conductivity type and dimensions equal to those of said first transistor ($T_1$) so as to

4

generate a base-emitter voltage drop ($V_{BE4}$) which is equal to said second voltage drop ($V_{BE2}$) and a corresponding control current ($I_{c4}$) fed to said first transistor.

4. A stage according to the preceding claims, characterized in that said first and fourth transistors ($T_1$,$T_4$) are of the NPN type and said second and third transistors ($T_2$,$T_3$) are of the PNP type.

5. A stage according to any of the preceding claims, characterized in that said first reference potential line is a supply line ($V_{cc}$) and said second reference potential line is a ground line, that said first transistor ($T_1$) is connected to said supply line ($V_{cc}$) with its collector terminal and to the collector terminal of said fourth transistor ($T_4$) with its emitter terminal, that said second transistor ($T_2$) is connected to said supply line ($V_{cc}$) with its emitter terminal through said resistive means (R) and to the emitter terminal of said third transistor ($T_3$) with its collector terminal, said third transistor ($T_3$) having its base and collector terminals short-circuited and connected to the ground line, and said fourth transistor ($T_4$) having its base terminal connected to the emitter terminal of said third transistor ($T_3$) and its emitter terminal connected to the ground line.

Fig.1

Fig. 2

Fig. 3

Fig.4